# EUROPEAN PATENT APPLICATION

(11) **EP 1 531 363 A1**
(43) Date of publication of application: **18.05.2005**
(21) Application number: 04077961.3
(22) Date of filing: 27.10.2004
(51) Int. Cl.: G03F 7/20, G03B 27/62, B65D 85/30

(54) **Reticle holder**

(30) Priority: 27.10.2003 EP 03078380; 13.10.2004 US 962751
(71) Applicant: ASML Netherlands B.V., 5504 DR Veldhoven (NL)
(72) Inventor: Heerens, Gert Jan, 2871 ZH Schoonhoven (NL); van de Ven, Bastiaan Lambertus Wilhelmus Marinus, 5211 GP Den Bosch (NL)
(74) Representative: Winckels, Johannes Hubertus F.

(57) **Abstract**

Assembly of a reticle and a reticle holder, wherein the state of the reticle holder (1) is adjustable between a form closed reticle blocking state and a reticle releasing state, wherein the reticle holder (1) is arranged to hold the reticle (MA) at least in a form closed manner in at least one direction (X, Y, Z) when the reticle holder (1) is in the blocking state, where the reticle holder (1) is arranged to release the reticle (MA) when the reticle holder (1) is in the releasing state.

The invention also relates to a system comprising an assembly of a reticle (MA) and reticle holder (201), as well as at least one detector (250), wherein the reticle (MA) comprises one or more markers (MRK), wherein the reticle holder (201) and the detector (250) are arranged to be kinematically aligned with respect to each other, wherein the detector (250) is arranged to detect said reticle markers (MRK) for positioning the reticle (MA) with respect to the reticle holder (201).

## Description

The invention relates to an assembly of a reticle and a reticle holder.

Such an assembly is known from the art. The reticle of the known assembly may for example be suitable and arranged for use in a lithographic process, carried out by a lithographic apparatus, to manufacture devices.

In particular, the known reticle holder is a storage box for storing and transporting the reticle. In certain cases, the reticle has to be aligned accurately with respect to the reticle holder before the assembly can be used in a manufacturing process. Usually, such alignment is carried out by a reticle prealigner.

From EP 0 284 003 A1 a reticle frame for positioning and holding a reticle is known. This known reticle holder is arranged to hold the reticle using clamping means. The clamping means consist of transversally movable springs which force the reticle against opposite screws using axial forces, as well as spring clips which apply pressure on the reticle.

European patent application EP 0 923 000 A2 discloses a stage apparatus, which is characterised by a movable stage for holding a substrate, and a number of levers, having counter masses, for applying forces to the substrate. Each lever is pivotally coupled to the stage. Units are provided to press the four corners of the reticle with the levers. During use, each lever imposes a force on a side of the substrate for cancelling the force of a vacuum adsorbing force acting thereon as the stage is accelerated. The force applied by said lever changes in accordance with the acceleration of the stage.

A problem of the known assemblies is, that it is relatively hard to maintain the reticle in a certain desired, for example aligned, position with respect to the reticle holder when being held thereby. As a consequence, the reticle can shift under the influence of vibrations and/or acceleration during transport of the assembly, leading to misalignment of the reticle. Besides, such undesired reticle movement may lead to undesired particle generation due to friction between the reticle and the reticle holder. Such particles may impair processes making use of the reticle, for instance vacuum processes and/or lithographic processes, wherein the processes require substantially contamination free process environments. In the known reticle holder, movement of the reticle is prevented by using relatively large clamping or friction forces. However, such forces lead to a high contact stress, which can damage the reticle and/or reticle holder.

The present invention aims to provide an improved assembly of a reticle and a reticle holder. Particularly, it is an object of the invention to provide an assembly of a reticle and a reticle holder, wherein the reticle can be maintained safely in a desired position with respect to the reticle holder.

According to the present invention, the assembly of the reticle and reticle holder is characterised by the features of claim 1.

The state of the reticle holder is adjustable between a reticle blocking state and a reticle releasing state. The reticle holder is arranged to hold the reticle at least in a form closed manner in at least one direction when the reticle holder is in the blocking state, wherein the reticle holder is arranged to release the reticle when the reticle holder is in the releasing state. Therefore, the reticle holder can prevent an undesired movement of the reticle in said at least one direction, using form closed reticle fixation, for example during transport of the assembly. Consequently, the reticle can maintain a certain position, for instance a certain aligned position, with respect to the reticle holder. Furthermore, particle creation can be prevented. Since the reticle can be held in a form closed manner, the reticle is preferably held using substantially no force closure in said at least one direction, for example clamping or friction forces. Therefore, the reticle can be held whilst the reticle experiences relatively little retaining forces, acted thereon by the reticle holder, so that reticle damage or fracture can be prevented. The present assembly of a reticle and reticle holder can have different appliances. The assembly can be used, for example, in combination with a lithographic apparatus, reticle inspecting means, a reticle transport system and such.

According to an advantageous embodiment of the invention, the reticle holder comprises at least one movable reticle retaining element which is movable between a reticle blocking position and a reticle releasing position for providing said form closed blocking state and releasing state respectively, wherein the at least one movable reticle retaining element is arranged to be fixed in the blocking position.

The reticle can simply be fixed in a form closed manner by fixing each reticle retaining element in its blocking position. The reticle is released when the at least one retaining element is moved from the blocking position to the releasing position. Preferably, the distance between each of the reticle retaining elements and the reticle is less than about 1 µm when the retaining element is in said blocking position and the reticle is held by the reticle holder, so that the form closure of the reticle is relatively tight and reticle movement is prevented well in said at least one direction. Furthermore, the distance between each reticle retaining element and the reticle can be, for example, larger than about 1 µm, particularly larger than about 100 µm, more particularly larger than about 1 mm, when the retaining element is in said releasing position to provide enough space for releasing the reticle. Said distance is preferably detected using suitable sensor means, wherein the movement of the movable retaining elements is preferably controlled by suitable control means, so that the form closure can be effected automatically.

According to a further embodiment of the invention, the reticle holder comprises at least a substance, for example a freezable fluid and/or a ferromagnetic fluid, which can be brought into a solid state and a deformable state for providing said form closed blocking state and releasing state respectively.

The reticle can simply be fixed in a form shaped manner by bringing said substance into the solid state. The reticle is released when the substance is brought into the deformable state. The substance may comprise different materials in different forms. The substance may comprise, for example, one or more fluids, a thermoplastic and/or a combination of these or any other suitable substance. Said solid state can be, for example, a state of high viscosity of the substance, wherein the substance has a lower viscosity in said deformable state. In case the substance is a fluid, said deformable state can be a fluid state, for example a liquid state, of the fluid. The substance can be contained, for example, in a flexible container to prevent that the reticle holder looses the substance when it is in said deformable state.

According to a preferred embodiment of the invention, the reticle holder comprises at least one immovable reticle retaining element which is arranged to abut at least part of the reticle for holding the reticle in said form closed manner.

The at least one immovable retaining element can, for example, cooperate with other parts of the reticle holder, particularly with said movable retaining element and/or with said substance, to hold the reticle in a form closed manner. The at least one immovable retaining element can further serve to align the reticle with respect to the reticle holder, which can make the use of a reticle prealigner abundant.

The invention further relates to a system comprising an assembly of a reticle and reticle holder.

As follows from the above, an assembly of a reticle and reticle holder is known from the art. The reticle holder may be used for facilitating the handling of the reticle. For instance, the reticle holder may be used to transport a reticle to and from a reticle stage. A disadvantage of the known assembly is, that the reticle holder needs to be removed from the reticle when the reticle is to be placed, for instance, in a storage box for storage and/or transportation thereof. The removal of the reticle holder leads to handling risks, lower MTBF and increases machine costs. An other problem of such an assembly is, that a desired precise positioning of the reticle with respect to the reticle holder is relatively complicated. Therefore, the positioning of the reticle onto the holder takes relatively much time, reducing the throughput of a lithographic apparatus or lithographic manufacturing method utilizing such reticle/reticle holder assembly.

The present invention aims to provide a system, wherein a reticle and reticle holder can be positioned relatively precise and fast with respect to each other.

According to the invention, this is achieved by a system, comprising an assembly of a reticle and reticle holder, as well as at least one detector, wherein the reticle comprises one or more markers, wherein the reticle holder and the detector are arranged to be kinematically aligned with respect to each other, wherein the detector is arranged to detect said reticle markers for positioning the reticle with respect to the reticle holder.

During use, the reticle can be aligned with respect to the reticle holder fast and accurately, making use of kinematical alignment on the one hand and marker-alignment on the other.

Preferably, the reticle holder is being kinematically aligned with respect to the at least one detector first. After the alignment of the reticle holder with respect to said detector, the reticle can simply be positioned with respect to the reticle holder utilizing detection of said markers by said detector. For instance, the reticle is positioned such with respect to the reticle holder, that the reticle obtains a certain desired position with respect to the holder, for instance a predetermined position, which position is suitable for placing the reticle in a lithographic apparatus without having to realign the reticle with respect to the reticle holder again. In that case, after the positioning of the reticle with respect to the reticle holder, the reticle holder can be transported, for instance, to a reticle stage of the lithographic apparatus for placing the reticle directly in a predetermined operating position thereon, without any further reticle alignment steps necessary.

Preferably, the system comprises at least one storage box for storing said assembly at least during the alignment thereof. In that case, the alignment of the reticle can be achieved in a relatively clean space, within the storage box, whereas handling risks -caused by any removal of the reticle and/or reticle from the storage box- are reduced.

For example, in a method for aligning a reticle with respect to a reticle holder, the assembly of the reticle and reticle holder can be placed in a storage box first. After that, the reticle and reticle holder are advantageously aligned with respect to each other, for instance using one or more reticle markers and marker detectors. The alignment of the reticle with respect to the reticle holder can be the same, for instance, as has been described above, such that the reticle holder can place the reticle in a operating position without any further reticle/reticle holder alignment needed. The storage box can protect the aligned reticle/reticle holder assembly before and/or after the assembly is to be used.

The assembly of the reticle and reticle holder may be arranged in various ways. For instance, the assembly may be an assembly according to any of claims 1-7, such that the reticle holder is arranged to hold the reticle at least in a form closed manner in at least one direction when the reticle holder is in the blocking state, where the reticle holder is arranged to release the reticle when the reticle holder is in the releasing state. This provides the above-mentioned advantages of the form-closure-fixation of the reticle.

According to one embodiment, the system comprises a support structure for supporting the reticle holder, wherein the structure comprises docking elements, or docking apertures, which are arranged to cooperate with docking apertures, or docking elements, of the reticle holder for kinematically docking the reticle holder onto the support structure, wherein said detector is located in a certain detector position with respect to the support structure for detecting said reticle markers. This provides an advantageous construction for docking the reticle holder and aligning the reticle. In one embodiment, the support structure is simply integrally attached to said detector.

According to a further aspect of the invention, there is provided a support structure, arranged for kinematically docking a reticle holder storage box, wherein the support structure is also arranged for kinematically docking a reticle holder which is being held in said storage box. In that case, the storage box as well as the reticle holder contained therein can be aligned accurately with respect to each other via the support structure. Therefore, positioning and/or transport of the reticle can be effected in a relatively simple manner and relatively fast. Thus, manufacturing costs of devices, manufactured using one or more reticles which are positioned using one ore more of said support structure, can be reduced. Also, the costs of a lithographic apparatus can be reduced when the apparatus is provided with one or more such support structures and/or when the apparatus is arranged to make use of one or more such support structures.

The invention further provides a reticle holder which is characterised by the features of claim 19.

Such reticle holder provides the above-mentioned advantages. Particularly, for the case that the reticle holder is a holder of an assembly of any of claims 1-7, a reticle can be held firmly by the reticle holder in said at least one direction, preferably without the application of reticle force fixation or using only a small amount of force fixation. Such reticle holder can be arranged in different ways. The reticle holder can be or comprise, for example, a frame for supporting the reticle. Besides, the reticle holder can be a reticle storage box. In that case, the storage box can be arranged to hold the reticle directly, wherein the reticle is not being held by any other reticle holding means. Furthermore, said reticle holder can be, for example, part of a storage box, such as a separate reticle holding frame, which can be removed from a further storage box part. Also, an outer storage box can be provided which is arranged for containing one or more inner storage boxes, wherein each inner storage box is arranged as a reticle holder.

Besides, for the case that the reticle holder is a holder of a system according to any of claims 8-16, the reticle and the reticle holder can be positioned relatively fast and precise with respect to each other, for instance such that the reticle can be placed directly in an operating position in a lithographic apparatus utilizing the holder. Also, in that case, preferably the reticle/reticle holder assembly can be stored in a suitable transportable storage box, for instance for protecting the assembly during storage and/or transportation thereof.

The invention also relates to a storage box. According to the invention, the storage box is characterised by the features of claim 20.

The assembly of the reticle and reticle holder can be contained by the storage box, for example to store the assembly in a well conditioned, relatively contamination free environment. Furthermore the storage box may serve to protect said assembly from adverse mechanical influences. Since the storage box is arranged to contain said assembly, the reticle can be handled with ease. For instance, the reticle holder does not have to be removed from the reticle in case the reticle needs to be stored in the storage box.

According to a further embodiment of the invention, the storage box comprises at least one retainer which is arranged to retain said reticle holder when the retainer is in a holder retaining state, wherein the retainer is arranged to release the reticle holder when the retainer is in holder releasing state.

The reticle holder can be retained in the storage box at will, utilizing said retainer. This improves the handling possibilities of the reticle and reticle holder assembly with respect to the storage box. For instance, the reticle holder can be moved from or to the storage box when the retainer is in said releasing state. Besides, a reticle can be moved from a reticle holder when that holder is retained by said retainer in the storage box. The reticle can, for example, be removed from the storage box without the reticle holder for cleaning purposes.

According to an aspect of the invention, the storage box is arranged to cooperate with a support structure of claim 17 or 18 for kinematically docking the storage box thereon, wherein at least part of the storage box is preferably optically transparent, such that said detector can detect said reticle marker simply optically during use, using relatively simple optical detectors.

The present invention further relates to a lithographic apparatus and a device manufacturing method.

A lithographic apparatus is a machine that applies a desired pattern onto a target portion of a substrate. Lithographic apparatus can be used, for example, in the manufacture of integrated circuits (ICs). In that circumstance, a patterning means, such as a mask, may be used to generate a circuit pattern corresponding to an individual layer of the IC, and this pattern can be imaged onto a target portion (e.g. comprising part of, one or several dies) on a substrate (e.g. a silicon wafer) that has a layer of radiation-sensitive material (resist). In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

According to an aspect of the invention, there is provided a lithographic apparatus comprising:
- an illumination system for providing a projection beam of radiation;
- a support structure for supporting patterning means, the patterning means serving to impart the projection beam with a pattern in its cross-section;
- a substrate table for holding a substrate; and
- a projection system for projecting the patterned beam onto a target portion of the substrate,
wherein the apparatus comprises at least one assembly according to any of claims 1-7 and/or at least one system according to any of claims 8-16 and/or at least one support structure according to claim 17 or 18 and/or at least one reticle holder according to claim 19 and/or at least one storage box according to any of claims 20-23.

Therefore, the above-mentioned advantages of said assembly, said system, said support structure, said storage box and/or said reticle holder are provided to the lithographic apparatus.

Particularly, the reticle can be handled and positioned relatively fast using the reticle holder, so the apparatus can have a low overhead and achieve a high productivity.

Moreover, the reticle can be aligned with respect to the reticle holder precisely and fast when using said system and/or said support structure, preferably such that the reticle can be placed on the support structure for supporting patterning means directly, using the reticle holder.

According to a further aspect of the invention, a device manufacturing method is characterised by the features of claim 25.

A substrate is provided, wherein a projection beam of radiation is provided using an illumination system. Patterning means are used to impart the projection beam with a pattern in its cross-section. The patterned beam of radiation is projected onto a target portion of the substrate. Since at least one assembly according to any of claims 1-7 and/or at least one system according to any of claims 8-16 and/or at least one support structure according to claim 17 or 18 and/or at least one reticle holder according to claim 19 and/or at least one storage box according to any of claims 20-23 is used for reticle handling, one or more reticles can be handled efficiently and safely. Besides, the reticle can be aligned accurately, using relatively little alignment steps.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm) and extreme ultra-violet (EUV) radiation (e.g. having a wavelength in the range of 5-20 nm), as well as particle beams, such as ion beams or electron beams.

The term "patterning means" used herein should be broadly interpreted as referring to means that can be used to impart a projection beam with a pattern in its cross-section such as to create a pattern in a target portion of the substrate. It should be noted that the pattern imparted to the projection beam may not exactly correspond to the desired pattern in the target portion of the substrate. Generally, the pattern imparted to the projection beam will correspond to a particular functional layer in a device being created in the target portion, such as an integrated circuit.

Patterning means may be transmissive or reflective. Examples of patterning means include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned. In each example of patterning means, the support structure may be a frame or table, for example, which may be fixed or movable as required and which may ensure that the patterning means is at a desired position, for example with respect to the projection system. Any use of the terms "reticle" or "mask" herein may be considered synonymous with the more general term "patterning means".

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the mask and the first element of the projection system. Immersion techniques are well known in the art for increasing the numerical aperture of projection systems.

Embodiments of the invention will now be described, by way of example only, with reference to the accompanying schematic drawings in which corresponding reference symbols indicate corresponding parts, and in which:
- Fig. 1 depicts a lithographic apparatus according to an embodiment of the invention;
- Fig. 2 schematically shows a partially opened side view of a first embodiment of the invention, wherein both the reticle and reticle holder are stored in the storage box;
- Fig. 3 shows a view similar to fig 2, wherein the reticle holder is being held in the storage box without the reticle
- Fig. 4 show a view similar to fig. 2 wherein the reticle holder is removed from the storage box;
- Fig. 5 schematically shows a top view of an assembly of a reticle and a reticle holder according to a second embodiment of the invention;
- Fig. 6 schematically shows a partially opened side view of a further aspect of the second embodiment of the invention, wherein the reticle is transversally fixed in the storage box using form closure.
- Fig.7 schematically shows a top view, similar to fig. 5, of a third embodiment of the invention;
- Fig. 8 schematically shows a top view, similar to fig. 5, of a fourth embodiment of the invention;
- Fig. 9 schematically shows a side view of a fifth embodiment of the invention; and
- Fig. 10 schematically shows a top view of a sixth embodiment of the invention.

### EMBODIMENTS

Unless specifically indicated, in this application, terms such as 'circa', 'about' or similar terms should be understood as meaning a value which can at least deviate plus and minus 10 % from the mentioned value.

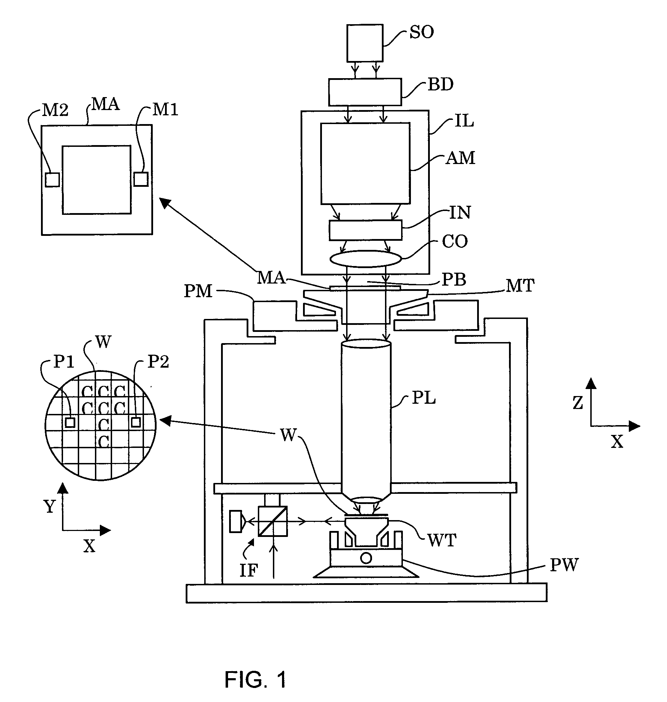

Figure 1 schematically depicts a lithographic apparatus according to a particular embodiment of the invention. The apparatus comprises:
- an illumination system (illuminator) IL for providing a projection beam PB of radiation (e.g. UV radiation, EUV radiation or an other type of radiation).
- a first support structure (e.g. a mask table) MT for supporting patterning means (e.g. a mask) MA and connected to first positioning means PM for accurately positioning the patterning means with respect to item PL;
- a substrate table (e.g. a wafer table) WT for holding a substrate (e.g. a resist-coated wafer) W and connected to second positioning means PW for accurately positioning the substrate with respect to item PL; and
- a projection system (e.g. a refractive projection lens) PL for imaging a pattern imparted to the projection beam PB by patterning means MA onto a target portion C (e.g. comprising one or more dies) of the substrate W.

As here depicted, the apparatus is of a transmissive type (e.g. employing a transmissive mask). Alternatively, the apparatus may be of a reflective type (e.g. employing a programmable mirror array of a type as referred to above).

The illuminator IL receives a beam of radiation from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising for example suitable directing mirrors and/or a beam expander. In other cases the source may be integral part of the apparatus, for example when the source is a mercury lamp. The source SO and the illuminator IL, together with the beam delivery system BD if required, may be referred to as a radiation system.

The illuminator IL may comprise adjusting means AM for adjusting the angular intensity distribution of the beam. Generally, at least the outer and/or inner radial extent (commonly referred to as σ-outer and σ-inner, respectively) of the intensity distribution in a pupil plane of the illuminator can be adjusted. In addition, the illuminator IL generally comprises various other components, such as an integrator IN and a condenser CO. The illuminator provides a conditioned beam of radiation, referred to as the projection beam PB, having a desired uniformity and intensity distribution in its cross-section.

The projection beam PB is incident on the mask MA, which is held on the mask table MT. Having traversed the mask MA, the projection beam PB passes through the lens PL, which focuses the beam onto a target portion C of the substrate W. With the aid of the second positioning means PW and position sensor IF (e.g. an interferometric device), the substrate table WT can be moved accurately, e.g. so as to position different target portions C in the path of the beam PB. Similarly, the first positioning means PM and another position sensor (which is not explicitly depicted in Figure 1) can be used to accurately position the mask MA with respect to the path of the beam PB, e.g. after mechanical retrieval from a mask library, or during a scan. In general, movement of the object tables MT and WT will be realized with the aid of a long-stroke module (coarse positioning) and a short-stroke module (fine positioning), which form part of the positioning means PM and PW. However, in the case of a stepper (as opposed to a scanner) the mask table MT may be connected to a short stroke actuator only, or may be fixed. Mask MA and substrate W may be aligned using mask alignment marks M1, M2 and substrate alignment marks P1, P2.

The depicted apparatus can be used in the following preferred modes:
1. In step mode, the mask table MT and the substrate table WT are kept essentially stationary, while an entire pattern imparted to the projection beam is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the mask table MT and the substrate table WT are scanned synchronously while a pattern imparted to the projection beam is projected onto a target portion C (i.e. a single dynamic exposure). The velocity and direction of the substrate table WT relative to the mask table MT is determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning means, and the substrate table WT is moved or scanned while a pattern imparted to the projection beam is projected onto a target portion C. In this mode, generally a pulsed radiation source is employed and the programmable patterning means is updated as required after each movement of the substrate table WT or in between successive radiation pulses during a scan. This mode of operation can be readily applied to maskless lithography that utilizes programmable patterning means, such as a programmable mirror array of a type as referred to above.

Combinations and/or variations on the above described modes of use or entirely different modes of use may also be employed.

During use of the apparatus shown in fig. 1, preferably a reticle storage box according to the present invention and/or a reticle holder according to the present invention is utilized for reticle handling.

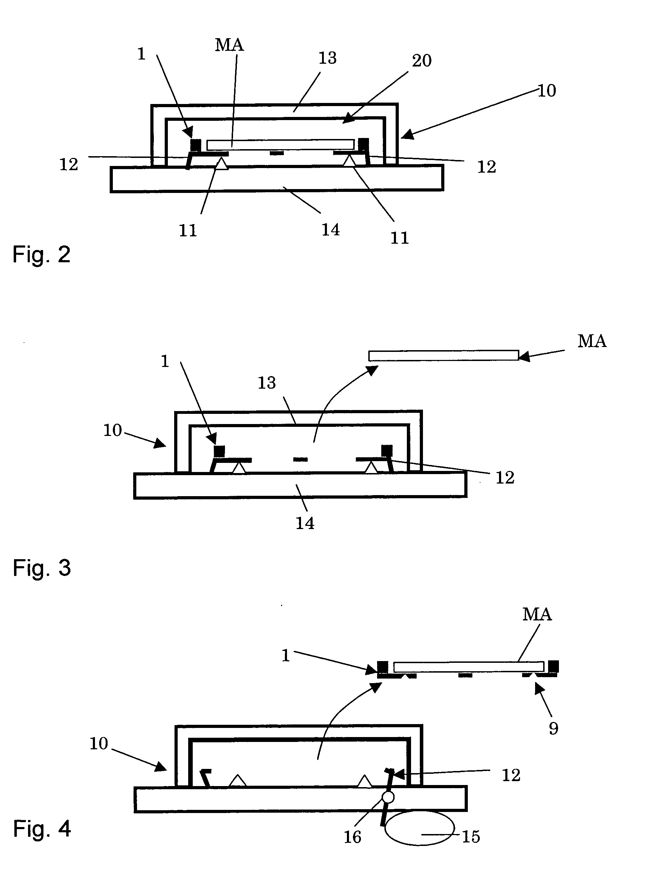

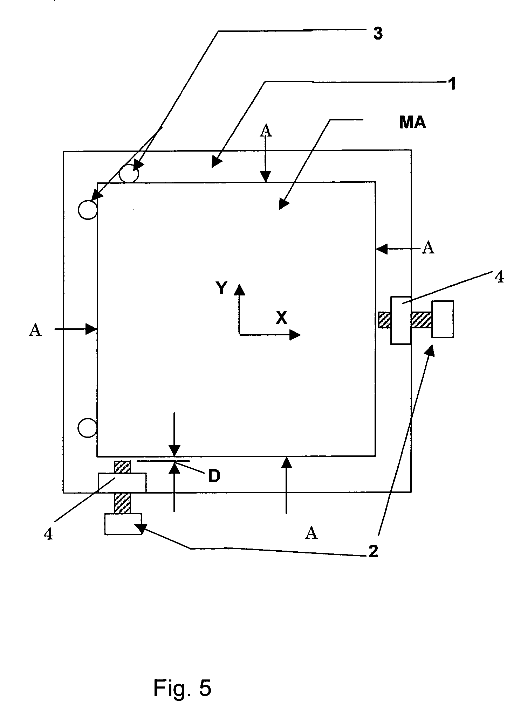

Figure 2 schematically shows a first embodiment of the present invention. The present embodiment comprises a storage box 10 which is arranged for storing a portable assembly of a reticle MA and a reticle holder 1. The reticle holder 1 can be, for instance, a kinematic handling frame for kinematically aligning the reticle MA with respect to a certain apparatus, particularly with respect to a lithographic apparatus. The reticle holder 1 can be arranged, for instance, according to the embodiments thereof shown in figures 5-8, for holding the reticle MA at least by form closure as is described below. On the other hand, the reticle holder 1 can be arranged to hold the reticle MA in a different manner, for example by force closure.

The storage box 10 comprises a base 14 and a cover 13 which enclose a storage space 20. In fig. 2, said assembly of a reticle MA and a reticle holder 1 is stored in the storage space 20 of the storage box 10. The cover 13 is detachably coupled to the base 14, for instance by clicking means, clamping means, spring means and/or any other suitable means. The base 14 of the storage box 10 is provided with support elements 11 for supporting the bottom side of the reticle holder 1. It is advantageous, when the reticle holder 1 and the support elements 11 are arranged to cooperate with each other for kinematical docking and positioning the reticle holder 1 onto the support elements 11. Such kinematical docking can be achieve in various ways, for instance, by using tapered pin-shaped support elements 11, whilst the bottom of the reticle holder 1 is provided with tapered receiving openings 9 for receiving the tapered support elements 11, as is clearly shown in figures 2-4.

Furthermore, the storage box 10 is provided with a number of retainers 12 which are arranged to retain the reticle holder 1 in the storage box. In the present embodiment, each retainer is formed as a pivotal arm 12 which is arranged to hold the reticle holder 1 when the arm 12 is in a holder retaining state. This holding state of the retaining arms 12 is shown in figures 2 and 3. The retaining arms 12 are movable to a releasing state, which is shown in fig. 4, to release the reticle holder 1. Movement of the retainers 12 can be achieved in different ways, for example using one or more electric actuators, electromechanical means, bi-metal, mechanical actuating means, spring means and such. The retainers 12 can be arranged, for example, to move automatically to a certain state when the storage box 10 is located onto or near a certain control mechanism 15. This is schematically depicted in fig. 5, showing a control element 15 which enables rotation of a retaining arm 12 about a pivot axis 16 towards the releasing state when the storage box 10 is positioned above the control element 15. Reverse movement of the retaining arm 12 can be achieved, for instance, by spring means, gravity, and/or other suitable means. Besides, the retainers 12 can be arranged and formed in various different ways, comprising for instance one or more pivotable, translatable, rotating, deformable retaining elements, gripping elements and/or such.

The storage box 10 is used to store an assembly of a reticle holder 1 and a reticle MA. Therefore, the reticle MA and the reticle holder 1 can be stored together, so that the reticle MA can be handled efficiently, particularly when the reticle MA and reticle holder 1 are to be used and/or transported jointly. The storage box 10 can prevent contamination of the whole assembly of reticle MA and reticle holder 1. Preferably, the reticle MA does not have direct contact with the storage box 10 when being stored therein by the reticle holder 1, which further reduces the chances of reticle contamination. Moreover, chances of reticle damage due to contact with the storage box 10 are reduced in this manner.

When the retainers 12 of the storage box 10 are in the retaining state, the reticle holder 1 is firmly withheld in the storage box 10 so that the reticle MA can be removed safely and easily from the reticle holder 1, as is depicted in fig. 3. During the reticle removal, the storage box cover 13 is separated temporarily from the base 14. Removal of the reticle MA may be desired, for example, to clean the reticle and/or to use the reticle MA in a certain manufacturing process and/or apparatus without the reticle holder 1. Removal and movement of the reticle MA can be achieved, for instance, by suitable actuator means, one or more robots, by hand and/or by other suitable means.

As is shown in fig. 4, the reticle holder 1 is released from the storage box 10 when the retainers 12 are in their releasing state. Then, in case the cover 13 is removed from the base 14, the reticle holder 1 can be removed from the storage box 10, together with the reticle MA. Removal and movement of the reticle holder 1 can also be achieved, for instance, by suitable actuator means, one or more robots, by hand and/or other suitable means. Removal of the reticle may be desired, for example, to clean the assembly MA, 1 and/or to use the reticle MA in a certain manufacturing process and/or apparatus together with the reticle holder 1.

Figure 5 shows a top view of a second embodiment of the present invention. The second embodiment comprises an assembly of a reticle MA and a reticle holder 1. The reticle holder 1 can be arranged in several ways to hold the reticle MA. In the present embodiment, the reticle holder is formed as a supporting frame 1 for supporting a side of the reticle MA. Besides, the reticle holder 1 can comprise and/or be part of, for instance, a reticle carrier, storage box or such.

According to the invention, the state of the reticle holder 1 is adjustable between a form closed reticle blocking state and a reticle releasing state. The reticle holder 1 is arranged to hold and/or position at least an edge A of the reticle MA in a form closed manner -in longitudinal direction- when the reticle holder 1 is in the blocking state. Therefore, the reticle holder 1 can hold the reticle MA firmly in a desired longitudinal reticle position, preferably without using force closure, resulting in relatively little or no friction between the reticle MA and reticle holder 1 during horizontal acceleration thereof. In the present embodiment, the reticle edge A comprises four substantially flat reticle surfaces which extend perpendicular to the plane of fig. 5. Besides, in the present embodiment, said longitudinal reticle direction is a horizontal direction as depicted in fig. 5 by arrows X and Y. The reticle holder 1 is arranged to release the reticle MA when the reticle holder 1 is in the releasing state.

As is clearly depicted in fig. 5, the reticle holder 1 of the second embodiment is provided with retaining elements 2, 3 for holding the reticle MA in a form closed manner. Two movable reticle retaining elements 2 are provided, which are located opposite two parts of the reticle edge A during use. The reticle holder 1 further comprises three immovable retaining elements 3 which are arranged to abut part of the remaining parts of reticle edge A. In the present embodiment, the immovable retaining elements 3 are located on the opposite side of said movable retaining elements 2 with respect to the form of the reticle MA.

The movable retaining elements 2 are movable between reticle blocking positions and reticle releasing positions for providing said form closed blocking state and releasing state respectively. Each movable reticle retaining element 2 is arranged to be fixed in said blocking position, such that the retailing element 2 is immobilized with respect to the reticle holder. The distance D between each of the movable reticle retaining elements 2 and the reticle edge A is less than about 1 µm when that retaining element 2 is in said blocking position, as is shown in fig. 5, so that the reticle MA is held on the support frame 1 in a substantially form closed state. Said distance D is preferably less than circa 100 nm, more preferably substantially 0 nm, such that the retaining elements 2 nearly or substantially make contact with the reticle edge A without applying a clamping force thereon. The distance D between each movable reticle retaining element 2 and the reticle edge A is larger than about 1 µm, particularly larger than about 100 µm, more particularly larger than about 1 mm, when the retaining element 2 is in said releasing position.

Each movable retaining element 2 may have only one fixed blocking position. On the other hand, it is advantageous when the blocking position of the retaining element 2 is adjustable between several blocking positions, for example to accommodate and retain reticles MA of different sizes and/or to precisely control the amount of form closure of the reticle.

Movement and fixation of each of the movable reticle retaining elements 2 can be achieved in various ways. The movable retaining element 2 can, for instance be slidably, translatably and/or pivotably connected to the support frame 1. In the second embodiment, each movable retaining element 2 movably extends through a guiding element 4 which is attached to the frame 1. The guiding element 4 can, for example, comprise interior screw thread for cooperation with outer screw thread of the retaining element 2. In that case, fixation of the movable retaining element 2 to the guiding element 4 can be achieved by the cooperation of said inner and outer screw tread coupling. Furthermore, the support frame 1 and/or guiding element 4 may comprise locking means to lock the movable retaining element 2 in the blocking position, for instance clicking means, clamping means, a locking pin or the like. Movement and fixation of the reticle retaining elements 2 can be achieved using various means, for instance one or more electrical and/of mechanical actuators, by hand, by electromagnetic means, by bi-metal and the like. The reticle holder 1 and/or an environment wherein the reticle holder 1 is to be placed can be provided with such means for moving and/or fixing the movable retaining elements 2.

Preferably, control means and sensor means are provided for automatically controlling the movement of said movable retaining elements 2. Said control means may comprise, for example, suitable computing means, feed-back means and/or electronics, for example one or more computers, microcontrollers or the like. Said sensor means may be, for example, arranged to measure the distance D between the reticle 1 and the retaining elements 2. The sensor means may be arranged in different ways, for instance to perform optical, electrical, capacitive, inductive, force measurements and/or any other suitable measuring methods. Said control means and sensor means are not shown in the figures.

During use, a reticle MA is placed on the reticle holder 1, with the reticle edge A abuting the immovable retaining elements 3, so that the reticle MA is automatically aligned with respect to the reticle holder 1. Before the reticle MA is brought onto the reticle holder 1, the movable retaining elements 2 are brought to said releasing position, so that ample space is provided between the retaining elements 2, 3 for placement of the reticle MA without damaging the reticle MA and/or reticle holder 1. Then, the movable retaining elements 2 are moved to the blocking positions and fixed in those positions, so that the reticle MA is fixed with respect to the reticle holder 1 by longitudinal form closure, such that the position of the reticle MA is maintained in the two longitudinal, orthogonal directions X, Y without clamping the reticle MA to the reticle holder 1. The reticle MA can be released by moving the movable retaining elements 2 back to the releasing positions, so that the reticle MA can safely be removed from the holder 1. During the movement of said movable retaining elements 2, the distance D between these elements 2 and the reticle is preferably detected by said sensor means, whereas the movement 2 of the elements 2 is preferably automatically controlled by said control means.

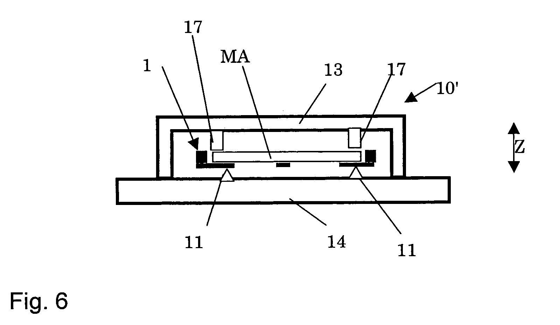

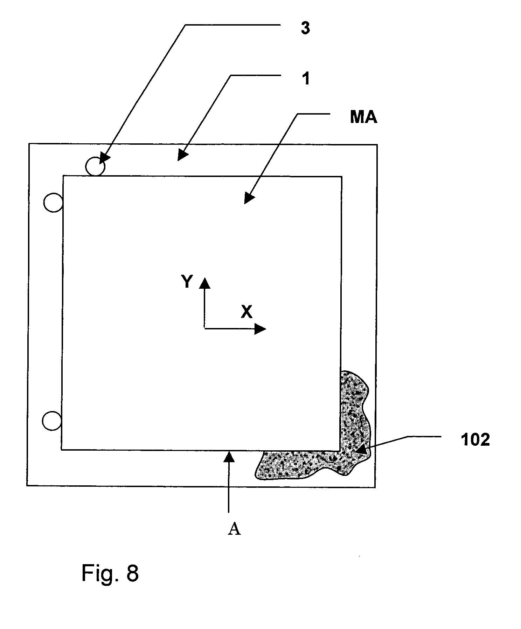

Preferably, the reticle MA is also fixed in a transversal direction Z with respect to the reticle holder 1. This further aspect of the second embodiment is shown in fig. 6, showing a storage box 10' comprising a cover 13 which can be detachably connected to a base 14, wherein the cover 13 is arranged to transversally fix the reticle MA when the reticle MA and reticle holder 1 are positioned between the cover 13 and the base 14. The base 14 of the storage box 10' comprises support elements 11 to support the reticle holder 1. Particularly, the cover 13 of the storage box 10' is provided with retaining elements 17 which extend at relatively small distances above the upper side of the reticle MA when the cover 13 is positioned onto the base 14 of the storage box 10', such that transversal movement, in a direction Z, of the reticle MA is prevented by form closure and not only by friction forces. Said small distances between these retaining elements 17 and the reticle MA can be, for example, smaller than about 1 µm. By using the storage box 10' of fig. 8 in combination with the reticle holder 1 of fig. 5, the reticle MA can be fixed by form closure in all directions X, Y, Z during storage, transport and such. The retaining elements 17 of the cover 13 of the storage box 10' can be arranged in various ways and located in different positions. The retaining elements 17 may be, for example, movably or immovably coupled to the box cover 13. Furthermore, the reticle holder 1 as such may comprise retaining elements for fixing the reticle MA thereto in a transversal direction Z by form closure.

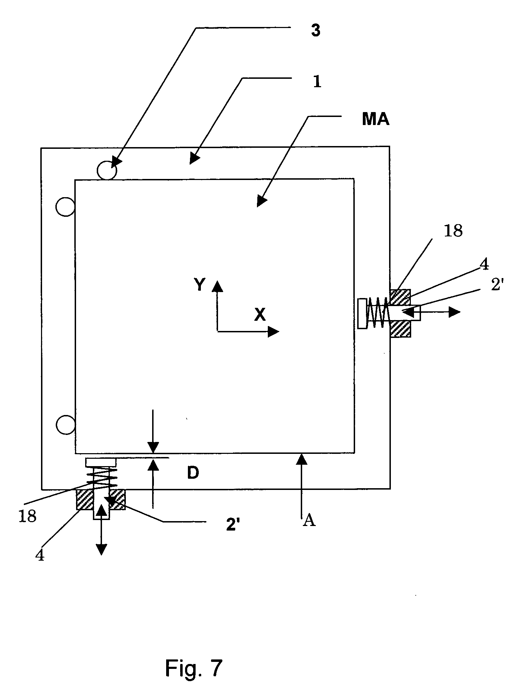

Fig. 7 shows a third embodiment of the invention, which differs from the embodiment shown in fig. 5 in that the reticle holder 1 comprises resilient elements, for example springs 18, for moving the movable retaining elements 2' towards the reticle MA. For instance, the resilient elements or springs 18 may have such spring constants that the retaining elements 2' press the reticle MA towards the opposite fixed retaining elements 3 without damaging the reticle MA. After the reticle MA is positioned onto the holder 1, the positions of the movable retaining elements 2' are fixed, such that the reticle MA is transversally held substantially by form closure and substantially not by force closure. To this aim, the guiding elements 4 can be arranged to guide the movable retaining elements 2' not farther towards the reticle MA than a suitable blocking position for blocking the reticle MA without applying a clamping or friction force thereon. In that case, the springs 18 can serve to fix the movable retaining elements 2' in the blocking positions. On the other hand, the reticle holder 1 can be provided with fixation means, not shown in the figure, which are arranged to retract each movable retaining element 2' over a small distance away from the reticle MA towards a suitable blocking position when the fixation means are activated. Said small distance can be, for example, a distance of less than circa 1 µm. In that case, the fixation means prevent that the springs 18 clamp the reticle MA between the retaining elements 2', 3'.

A fourth embodiment of the invention is depicted in fig. 8. The reticle holder 1 of the fourth embodiment comprises a substance 102, for example a freezable fluid a ferromagnetic fluid and/or a thermoplastic, which can be brought into a solid state and a deformable state for providing said blocking state and releasing state respectively. In the present embodiment, the reticle holder 1 comprises three fixed retaining elements 3 for retaining the reticle edge A on the opposite side with respect to the substance 102. Therefore, relatively little of the substance 102 can be used to fix the reticle MA with respect to the reticle holder 1. During use, the reticle MA is positioned with the edge A against the fixed retaining elements 3, while the substance 102 is in said deformable state. Then, the substance 102 is simply brought into the blocking state to fix the reticle MA. Alternatively, the reticle holder 1 can be provided with said substance 102 which extends around a larger portion of the reticle edge A, for example completely around the edge A, to provide reticle fixation.

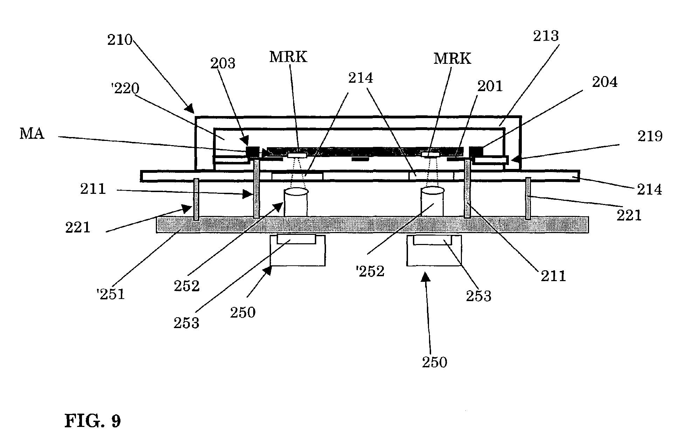

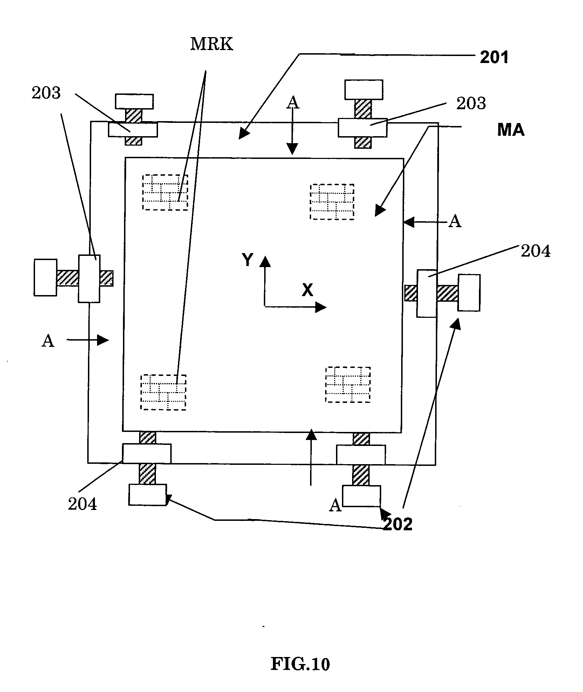

Figure 9 schematically depicts a fifth embodiment of the invention. The fifth embodiment is an alignment system comprising an assembly of a reticle MA and reticle holder 201. The assembly MA, 201 may be, for example, similar to or the same as an assembly according to any of the embodiments shown in figures 5,7,8. In that case, the state of the reticle holder 201 is adjustable between a form closed reticle blocking state and a reticle releasing state. Besides, the assembly may be as shown in the sixth embodiment of figure 10, wherein the reticle holder 201 comprises several adjustable retainers 202, 203 for holding the reticle MA by form closure or, which is less preferable, by force fixation.

In the fifth embodiment, the bottom side of the reticle MA comprises a number of alignment markers MRK. In fig. 10, these markers MRK are schematically shown by dashed lines. Each of the markers MRK is optically detectable. Such markers MRK are generally known in the art, and may comprise various structures and marker configurations suitable for alignment purposes.

The fifth embodiment also comprises an optical system for aligning the reticle MA with respect to the reticle holder 201. The optical system comprises number of detectors 250. The detectors 250 are arranged to detect said reticle markers MRK for positioning the reticle MA with respect to the reticle holder 201. To this aim, each detector 250 comprises an optical sensor 253 and at least one optical element 252, such as microscope optics 252 comprising one or more lenses or the like. The microscope optics 252 is arranged to enlarge the image of a reticle marker MRK onto the optical sensor 253, when the reticle MA is in the position as shown in fig. 9. The optical sensor 253 may be, for example, an electronic camera, a CCD camera and/or the like. Said optics 252 may be, for instance, controllable for focussing the images of the markers during use.

Besides, according to the invention, the reticle holder 201 and the detector 250 are arranged to be kinematically aligned with respect to each other. In the present embodiment, this is simply achieved by a support structure 251 for supporting the reticle holder 1, wherein the reticle holder 201 can be kinematically aligned with respect to that support structure 251, whereas said detectors 250 are located in certain predetermined detector positions with respect to the support structure 251 for detecting said reticle markers MRK. In the present embodiment said detectors 250 are simply attached to said support structure 251. Alternatively, one or more detectors 250 may also be at least partly located in other positions, for example being detached from the support structure 251.

The support structure 251 comprises first docking elements 211 which are arranged to cooperate with docking apertures of the reticle holder 201 for kinematically docking the reticle holder 201 onto the support structure 251. The reticle holder 201 can be, for instance, a kinematic handling frame for kinematically aligning the reticle MA with respect to a certain apparatus, particularly with respect to a lithographic apparatus. The reticle holder 201 may also comprises, for example, an number of reticle handling brackets. The support structure preferably provides at least three, more preferably only three, kinematic support points for cooperating with at least three kinematic grooves, for example V-grooves, of a reticle holder 201. Said support point may be, for instance, round-tip pins or suchlike.

Alternatively, for instance, the support structure 251 comprises one or more docking apertures which are arranged to cooperate with suitable docking elements of the reticle holder for kinematically docking the reticle holder onto the support structure 251.

The functioning of such kinematical docking has already been described above. Such kinematical docking can be achieved in various ways, for instance, by using tapered pin-shaped support elements 211, whilst the bottom of the reticle holder 201 is provided with tapered receiving openings, or V-shaped grooves, for receiving the tapered support elements 211, as has already been shown schematically in figures 2-4. By applying such kinematic positioning, the reticle holder 201 can be aligned fast and accurately with respect to the detectors 250.

The fifth embodiment of the invention also comprises a storage box 210 which is arranged for storing the assembly of a reticle MA and the reticle holder 201. Such a storage box has the above mentioned advantages. For instance, the reticle MA and the reticle holder 201 can be stored together, so that the reticle MA can be handled efficiently, particularly when the reticle MA and reticle holder 201 are to be used and/or transported jointly. The storage box 210 can prevent contamination of the whole assembly of reticle MA and reticle holder 201.

The storage box 201 of the fifth embodiment may be, for instance, substantially the same as or similar to the one shown in figures 2-4, 6. The storage box 210 of the fifth embodiment comprises a base 214 and a cover 213 which enclose a storage space 220. The cover 213 is detachably coupled to the base 214, for instance by clicking means, clamping means, spring means and/or any other suitable means. In the present embodiment, the base 214 of the storage box 210 is provided with openings for allowing the support elements 211 of the support structure 251 to reach the reticle holder 201, when the reticle holder 201 is stored in the storage box 210. Said opening of the box base 214 may be, for instance, through-holes, perforations or the like. Suitable closing means, for instance caps, inserts or the like, may be provided for closing there openings when said support elements 211 do not extend therethrough. Such closing means are not shown in fig. 9. Besides, the present storage box 201 comprises side supports 219 for holding the reticle holder 201 at a certain position in the storage box 210. Such side supports 219 may be arranged in various ways, and may be, for example, attached to the bottom 214 of the storage box. Also, the storage box 210 may be provided with a number of retainers which are arranged to retain the reticle holder 201 in the storage box, for example after the reticle holder 201 has been aligned kinematically onto the support structure 251. Such retainers may be provided in various ways, see for instance the above concerning figures 2-4, and have not been shown in fig. 9.

The storage box 210 is at least partially optically transparent, such that the detectors 250 can optically detect the reticle markers MRK when the system is in the operating position as is shown in fig. 9. To this aim, in the present embodiment, at least the parts 214' of the bottom 214 of the storage box, which parts 214' extend between the markers MRK and opposite microscope optics 252 of the detectors 250 during use, are made of transparent material, for example a transparent plastic, glass or the like.

In the present embodiment, the support structure 251 is also arranged for kinematically docking the storage box 210 thereon. Particularly, the support structure comprises second docking elements 221, or - alternatively- second docking apertures, which are arranged to cooperate with second docking apertures, or alternative second docking elements, of the reticle holder storage box 210. The storage box is arranged to cooperate with the support structure 251, via said docking elements and docking apertures, for kinematically docking the storage box 210 onto the support structure 251. Also in this case, the kinematical docking can be achieved in various ways, for instance in a manner described above.

Besides, the alignment system shown in fig. 9 comprising a mechanism 203, 204 for moving the reticle MA and reticle holder 201 with respect to each other, for aligning the markers MRK of the reticle MA with respect to the optical sensors 253 of said detectors 250 when the reticle holder 201 has been kinematically positioned onto the support structure 251. Such mechanism can be provided in various ways. For example, the mechanism 203, 204 may be the same as, or at least comprise the adjustable retainers 202, 203 of the reticle holder 201 embodiment shown in fig. 10. On the other hand, the storage box 210 may be provided, for instance, with such a mechanism for moving the reticle MA with respect to the reticle holder 201. Besides, such a mechanism for manipulating the reticle with respect to the reticle holder 201 may be an automated and/or manually operable mechanism.

The fifth embodiment preferably comprises control means for automatically controlling the movement of various system parts with respect to each other during use. Also, the fifth embodiment preferably comprises movement means for moving the reticle holder 201, storage box 210 and/or support structure 251 with respect to each other, for example one or more robots, actuators and/or the like. Said control means may also be arranged for processing data and/or signals being generated by the detectors as a result of marker MRK detection. Said control means may comprise, for example, suitable computing means, feed-back means and/or electronics, for example one or more computers, microcontrollers, software or the like. Said control means and movement means are not shown in figure 9.

During use of the fifth embodiment, the assembly of the reticle MA and reticle holder 201 can be stored in the storage box 210, for protecting the assembly and for prevention contamination thereof. Then, the reticle MA and the reticle holder 201 can be simply aligned with respect to each other in the following manner, without having to remove the reticle and/or reticle holder from the storage box 210.

To this aim, the storage box 210 is positioned kinematically onto the second docking elements 221 of the support structure 251. During this positioning, the first docking elements 211 of the support structure 251 reach through the respective openings of the storage box bottom 214 and cooperate with the reticle holder 201 for achieving the kinematical alignment thereof. As a result, the reticle holder 201 has been kinamatically aligned with respect to the optical detectors 250, which have known positions with respect to the support structure 251. Preferably, each of said kinematical alignments is achieved by three kinematic support points cooperating with three kinematic grooves.

Then, the reticle MA is being positioned with respect to the reticle holder 201 utilizing detection of said markers MRK by said detectors 250. Herein, images of the markers MRK are being projected onto the optical sensors 253 by respective microscope optics 252. The positioning of the reticle MA is achieved by said moving mechanism 203, 204. Particularly, the reticle MA and reticle holder 201 are manipulated in such a way with respect to each other, that the markers MRK of the reticle are aligned with respect to the optical sensors 253 of said detectors 250, so that the markers MRK reach certain desired, pre-known marker positions with respect to the detectors 250. For example, said control means is arranged for realising such a reticle movement with respect to the reticle holder. The reticle MA is aligned such, for instance, that the reticle can be placed on a reticle stage MT of a lithographic apparatus directly, using the reticle holder 201, without any further alignment steps necessary. A relatively precise positioning can be achieved by the application of microscope optics 252, which enlarge images of the markers MRK onto the optical sensors 253.

Preferably, the reticle MA is being fixed to the reticle holder 201 after the reticle has been positioned with respect to the reticle holder 201. Then, the storage box 210 can, for instance, be transported to a location wherein the reticle MA is to be used, for example to a lithographic apparatus as described above for use in the manufacturing of devices. After the above-described reticle alignment, the reticle MA can preferably be placed directly on the reticle stage MT of the lithographic apparatus, leading to relatively low down-times and high throughput of the apparatus.

In the present fifth embodiment, the reticle holder 201 and the mask MA are simply aligned with respect to one another, utilizing optical means MRK, 250 and kinematic alignment means 211. Therefore, the handling of the reticle is facilitated. For example, the reticle MA can already be located on the holder 201 when the reticle holder 201 is being stored in the storage box 210. After that, the reticle MA can be aligned with respect to the reticle holder 201 without having to remove the reticle/reticle holder assembly from the storage box 210. Thus, the alignment of the reticle MA can be achieved in a relatively clean, particle free environment. Herein, the support structure 251 and said detectors 250 may function as a pre-aligner, providing for a fast, clean and efficient reticle alignment.

While specific embodiments of the invention have been described above, it will be appreciated that the invention may be practiced otherwise than as described. The description is not intended to limit the invention.

The storage box can be arranged for storing an assembly comprising at least a reticle and a reticle holder, wherein the state of the reticle holder is, for instance, not adjustable between a form closed reticle blocking state and a reticle releasing state, wherein the storage box is provided with at least one retainer which is arranged to retain said reticle holder. This provides the above-mentioned advantages of said retainer independently of holding the reticle by form closure. In particular, the handling possibilities of the reticle and reticle holder assembly are improved when using such storage box, as is depicted in figures 2-4.

The reticle MA can also be provided in various ways and shapes, for instance rectangular, square, circular or such.

Furthermore, the reticle holder and/or storage box can be arranged to transport and/or store the reticle in a horizontal, vertical and/or other reticle state. The reticle holder and/or storage box can further be arranged for positioning the reticle with respect to an environment and/or an apparatus.

Each reticle holder can be arranged to hold one or more reticles. The same holds for said storage box. The storage box can also be arranged to hold one or more reticle holders, for example one or more reticle holding frames and/or one or more inner reticle storage boxes.

Besides, the reticle can be held in one or more directions substantially by form fixation, wherein force fixation can for example be applied to hold the reticle in remaining directions.

Further, the reticle MA is preferably held substantially by form closure in at least one direction and substantially not by force closure in that direction. Herein, the term "substantially not by force closure" has to be construed broadly, for example such, that the reticle holder applies a remaining retaining force of about 10 N or less to the reticle.

Besides, a reticle alignment method according to the present invention, as described above, can be carried out in a vacuum environment, for example in a separate module that is designed for that function. Also, the a reticle alignment can be carried out, for instance, in a storage module, load lock, scanner or in other devices.

Besides, a system according to at least claim 8 may comprise, for instance, one or more assemblies of reticles MA and reticle holders 201, each reticle holder being arranged for holding a respective reticle, wherein - preferably- each assembly MA, 201 can be removably stored in a suitable storage box 210. Besides, each said storage box 210 and/or reticle holder 201 may be, for instance, arranged to be manually transported or the-like.

In this application, the term "form closure" or "form closed manner" with respect to the holding of the reticle can be understood as meaning, that the reticle is being geometrically constrained, viewed in at least one direction, to prevent movement of the reticle along that direction -with respect to the reticle holder- without the use of friction and/or clamping (see figures 2-8).

## Claims

1. Assembly of a reticle and a reticle holder, wherein the state of the reticle holder (1) is adjustable between a form closed reticle blocking state and a reticle releasing state, wherein the reticle holder (1) is arranged to hold the reticle (MA) at least in a form closed manner in at least one direction (X, Y, Z) when the reticle holder (1) is in the blocking state, where the reticle holder (1) is arranged to release the reticle (MA) when the reticle holder (1) is in the releasing state.

2. Assembly according to claim 1, wherein the reticle holder comprises at least one movable reticle retaining element (2) which is movable between a reticle blocking position and a reticle releasing position for providing said form closed blocking state and releasing state respectively, wherein the at least one movable reticle retaining element (2) is arranged to be fixed in the blocking position.

3. Assembly according to claim 2, wherein the distance between each of the reticle retaining elements (2) and the reticle (MA) is less than about 1 µm when the retaining element (2) is in said blocking position and the reticle (MA) is held by the reticle holder (1).

4. Assembly according to claim 3, wherein the distance between each reticle retaining element (2) and the reticle (MA) is larger than about 1 µm, particularly larger than about 100 µm, more particularly larger than about 1 mm, when the retaining element (2) is in said releasing position.

5. Assembly according to any of the preceding claims, wherein the reticle holder (1) comprises at least a substance (102), for example a freezable fluid, a ferromagnetic fluid and/or thermoplastic, which can be brought into a solid state and a deformable state for providing said form closed blocking state and releasing state respectively.

6. Assembly according to any of the preceding claims, wherein the reticle holder (1) comprises at least one immovable reticle retaining element (3) which is arranged to abut at least part of the reticle (MA) for holding the reticle (MA) in said form closed manner.

7. Assembly according to any of the preceding claims, wherein the reticle holder comprises a support frame (1) for supporting a side of the reticle.

8. System comprising an assembly of a reticle (MA) and reticle holder (201), as well as at least one detector (250), wherein the reticle (MA) comprises one or more markers (MRK), wherein the reticle holder (201) and the detector (250) are arranged to be kinematically aligned with respect to each other, wherein the detector (250) is arranged to detect said reticle markers (MRK) for positioning the reticle (MA) with respect to the reticle holder (201), wherein the system preferably comprises at least one storage box (210) for storing said assembly (MA, 201) at least during the positioning of the reticle (MA) with respect to the reticle holder (201).

9. System according to claim 8, wherein said assembly is an assembly according to any of claims 1-7, such that the reticle holder (201) is arranged to hold the reticle (MA) at least in a form closed manner in at least one direction (X, Y, Z) when the reticle holder (201) is in the blocking state, where the reticle holder (201) is arranged to release the reticle (MA) when the reticle holder (201) is in the releasing state.

10. System according to claim 8 or 9, comprising a mechanism (203, 204) for moving the reticle (MA) and reticle holder (201) with respect to each other, and preferably a mechanism (203, 204) for moving the reticle (MA) when said assembly (MA, 201) is located in said storage box (210).

11. System according to any of claims 8-10, comprising a support structure (251) for supporting the reticle holder (201), wherein the structure comprises docking elements (211), or docking apertures respectively, which are arranged to cooperate with docking apertures, or docking elements respectively, of the reticle holder (201) for kinematically docking the reticle holder onto the support structure (251), wherein said detector (250) is located in a certain detector position with respect to the support structure (251) for detecting said reticle markers (MRK) during use.

12. System according to claim 11, wherein said detector (250) is attached to said support structure (251)

13. System according claim 11 or 12, wherein the support structure comprises at least three kinematic support points for cooperating with at least three kinematic grooves of a reticle holder (201).

14. System according to any of claims 8-13, wherein said detector comprises at least one optical sensor (253) for detecting said marker (MRK).

15. System according to any of claims 8-14, wherein said detector at least comprises at least one optical element (252), for example microscope optics, for enlarging an image of at least one of said markers (MRK).

16. System according to any of claims 8-15, wherein said detector comprises at least one electronic camera, for example a CCD camera, for detecting said marker (MRK).

17. Support structure, for example a support structure of a system according to any of claims 11-13, arranged for kinematically docking a reticle holder (201) thereon, wherein the support structure (251) is preferably also arranged for kinematically docking a reticle holder storage box (210) when said reticle holder (201) is being held in that storage box (210).

18. Support structure according to claim 17, comprising first docking elements (211), or first docking apertures, which are arranged to cooperate with first docking apertures, or first docking elements respectively, of the reticle holder (201) wherein the support structure (251) preferably also comprises second docking elements (221), or second docking apertures respectively, which are arranged to cooperate with second docking apertures, or second docking elements respectively, of the reticle holder storage box (210).

19. Reticle holder of an assembly of any of claims 1-7 and/or of a system of any of claims 8-16.

20. Storage box, arranged to contain and/or containing an assembly according to any of the claims 1-7 and/or an assembly of a system according to any of claims 8-16.

21. Storage box according to claim 20, comprising at least one retainer (12) which is arranged to retain said reticle holder (1) when the retainer (12) is in a holder retaining state, wherein the retainer (12) is arranged to release the reticle holder (1) when the retainer (12) is in a holder releasing state.

22. Storage box, arranged for storing an assembly comprising at least a reticle (MA) and a reticle holder (1), wherein the storage box is provided with at least one retainer (12) which is arranged to retain said reticle holder (1) when the retainer (12) is in a holder retaining state, wherein the retainer (12) is arranged to release the reticle holder (1) when the retainer (12) is in a holder releasing state.

23. Storage box according to any of claims 20-22, wherein the storage box is arranged to cooperate with a support structure of claim 17 or 18 for kinematically docking the storage box thereon, wherein at least part (214') of the storage box (210) is preferably optically transparent, such that said detector (250) can detect said reticle marker (MRK) during use.

24. A lithographic apparatus comprising:
- an illumination system for providing a projection beam of radiation;
- a support structure for supporting patterning means, the patterning means serving to impart the projection beam with a pattern in its cross-section;
- a substrate table for holding a substrate; and
- a projection system for projecting the patterned beam onto a target portion of the substrate,
wherein the apparatus comprises at least one assembly according to any of claims 1-7 and/or at least one system according to any of claims 8-16 and/or at least one support structure according to claim 17 or 18 and/or a reticle holder according to claim 19 and/or at least one storage box according to any of claims 20-23.

25. A device manufacturing method, wherein a substrate is provided, wherein a projection beam of radiation is provided using an illumination system, wherein patterning means are used to impart the projection beam with a pattern in its cross-section, and wherein the patterned beam of radiation is projected onto a target portion of the substrate, wherein at least at least one assembly according to any of claims 1-7 and/or at least one system according to any of claims 8-16 and/or at least one support structure according to claim 17 or 18 and/or a reticle holder according to claim 19 and/or at least one storage box according to any of claims 20-23 is used for reticle handling.

26. Use of a reticle holder according to claim 19, wherein the reticle holder (1) holds a reticle (MA) in a form closed manner in at least one direction (X, Y, Z), and preferably in at least two directions (X, Y), for instance two orthogonal directions (X, Y).

27. A method for aligning a reticle (MA) with respect to a reticle holder (201), wherein the reticle comprises one or more markers (MRK), wherein the reticle holder (201) is being kinematically aligned with respect to at least one detector (250), after which the reticle is being positioned with respect to the reticle holder (201) utilizing detection of said markers (MRK) by said detector (250).

28. A method according to claim 27, wherein the reticle (MA) and reticle holder (201) are moved in such a way with respect to each other, that the one or more markers (MRK) of the reticle are aligned with respect to one or more optical sensors of said detector (250).

29. A method according to claim 27 or 28 wherein the reticle (MA) is being fixed to the reticle holder (201) after the reticle has been positioned with respect to the reticle holder.

30. Method according to any of claims 27-29, wherein an assembly of a reticle and a reticle holder according to any of claims 1-7 and/or a system according to any of claims 8-16 is used.

31. A method according to any of claims 27-30 ,wherein the kinematical alignment is achieved by three kinematic support points cooperating with three kinematic grooves.

32. A method according to any of claims 27-31, wherein the assembly of the reticle (MA) and reticle holder (1; 201) is first being placed in a storage box (10; 210), after which the reticle (MA) and reticle holder (1; 201) are being aligned with respect to each other.

33. A method according to any of claims 27- 32, wherein said detector (250) has a predetermined position with respect to a support structure (251), wherein the assembly of the reticle (MA) and reticle holder (201) is placed in a storage box (210), wherein the storage box (210) is being kinematically aligned with respect to said support structure (251), wherein said reticle holder (201) is being kinematically aligned with respect to said support structure (251).

34. A method according to any of claims 27-33, wherein the reticle is positioned such with respect to the reticle holder, that the reticle obtains a certain desired position with respect to the holder, for instance a predetermined position, which position is suitable for placing the reticle on a reticle support structure (MT) of a lithographic apparatus without having to realign the reticle with respect to the reticle holder again.
